# EUROPEAN PATENT APPLICATION

(11) **EP 2 426 744 A2**
(43) Date of publication of application: **07.03.2012**
(21) Application number: 11179555.5
(22) Date of filing: 31.08.2011
(51) Int. Cl.: H01L 33/48, H01L 33/64

(54) **Light emitting diode package and manufacturing method thereof**

(30) Priority: 02.09.2010 KR 20100085990
(71) Applicant: Samsung LED Co., Ltd., Gyeonggi-do, 443-743 (KR)
(72) Inventor: Lee, Young Jin, 137-130 Seoul (KR); Kim, Hyung Kun, 443-470 Gyeonggi-do (KR); Moon, Kyung Mi, 443-733 Gyeonggi-do (KR); Woo, Gwang Bok, 465-715 Gyeonggi-do (KR)
(74) Representative: Grünecker, Kinkeldey, Stockmair & Schwanhäusser

(57) **Abstract**

A light emitting diode (LED) package is disclosed. The LED package includes a lead frame comprising a thermal pad and at least two electrode pads disposed at a distance from the thermal pad; at least one LED mounted on the thermal pad and electrically connected with the at least two electrode pads through a wire; a package mold comprising a first cavity to receive the thermal pad and the at least two electrode pads and to partially expose the thermal pad and the at least two electrode pads through a first surface of the package mold, the first surface on which the at least one LED is mounted, and exposing the thermal pad and the at least two electrode pads through a surface coplanar with a second surface opposite to the first surface; and a molding unit disposed in the first cavity.

## Description

### CROSS-REFERENCE TO RELATED APPLICATION

This application claims the benefit of Korean Patent Application No. 10-2010-0085990, filed on September 2, 2010, in the Korean Intellectual Property Office, the disclosure of which is incorporated herein by reference.

### BACKGROUND

### 1. Field

Example embodiments of the following description relate to a light emitting diode (LED) package capable of increasing heat radiation efficiency by mounting an LED on a thermal pad, and a fabrication method thereof.

### 2. Description of the Related Art

A light emitting diode (LED) is a semiconductor device which forms light sources by varying compound semiconductor materials, such as GaAs, AlGaAs, GaN, InGaInP and the like, and thereby embodies various colors.

Recently, general LED products having a low brightness are being developed into high-quality LED products having a high brightness. In addition, as blue and white LEDs having a high performance are realized, application of the LED is expanding to displays, next-generation lighting, and the like.

A conventional LED package includes a first lead frame and a second lead frame mounted on a package mold, being electrically isolated from each other, and an LED mounted on either of the first lead frame and the second lead frame. Since the conventional LED package emits heat generated from the LED through the first or second lead frame, heat radiation efficiency is low. The heat radiation efficiency may be considerably reduced when the LED package includes a plurality of LEDs.

Also, to mount the plurality of LEDs, the LED package is to be equipped with a plurality of lead frames arranged at predetermined intervals from one another which hinders size reduction of the LED package and also limits high integration of the plurality of LEDs.

To overcome the above shortcomings, a surface-mounted LED package using a ceramic substrate has been introduced. However, the surface-mounted LED package is expensive and fragile while having a low heat radiation efficiency.

### SUMMARY

According to example embodiments, there may be provided a highly integrated light emitting diode (LED) package implemented by mounting at least one LED on a thermal pad being electrically unpolarized and by electrically connecting the at least one LED with at least two electrode pads, and a method of fabricating the same.

According to example embodiments, there may be also provided a highly integrated LED package capable of being surface-mounted and capable of increasing heat radiation efficiency by exposing a thermal pad and at least two electrode pads through a coplanar surface of a lower surface of the package mold, and a method of fabricating the same.

According to example embodiments, there may be also provided an LED package capable of protecting a wire from a thermal shock by covering a thermal pad, at least two electrode pads, an LED, and the wire along with a molding material put in a first cavity, and a method of fabricating the same.

According to example embodiments, there may be also provided an LED package applicable to a printed circuit board (PCB) of all types of driving voltage without separately fabricating a PCB according to the driving voltage, and a method of fabricating the same.

According to example embodiments, there may be also provided an LED package capable of stably driving by preventing damage due to a short circuit, and a method of fabricating the same.

The foregoing and/or other aspects are achieved by providing a light emitting diode (LED) package including a lead frame including a thermal pad and at least two electrode pads disposed at a distance from the thermal pad; at least one LED mounted on the thermal pad and electrically connected with the at least two electrode pads through a wire; a package mold including a first cavity to receive the thermal pad and the at least two electrode pads, and to partially expose the thermal pad and the at least two electrode pads through a first surface of the package mold, the first surface on which the at least one LED is mounted, and to expose the thermal pad and the at least two electrode pads through a surface coplanar with a second surface opposite to the first surface; and a molding unit disposed in the first cavity.

The molding unit may cover the thermal pad, the at least two electrode pads, the at least one LED, and the wire, which are exposed through the first cavity.

The package mold may further include a second cavity which has a step from the first cavity and is disposed at an upper portion of the first cavity.

The LED package may further include a lens unit disposed in the second cavity.

The at least one LED may include two electrodes horizontally arranged on an upper surface thereof, the two electrodes may each be connected to the at least two electrode pads, and the thermal pad may be electrically unpolarized.

The at least two electrode pads may be symmetrically disposed with respect to the thermal pad on the second surface.

The first cavity may include a first recess to expose a region mounting the at least one LED on the thermal pad; and a second recess to partially expose the at least two electrode pads, being connected with the first recess.

The at least two electrode pads may include a penetration portion disposed in a region electrically connected with the wire.

The foregoing and/or other aspects are achieved by providing a method of fabricating a light emitting diode (LED) package, including forming a lead frame including a thermal pad and at least two electrode pads disposed at a distance from the thermal pad; forming a package mold by injection molding, the package mold including a first cavity to receive in the cavity the thermal pad and the at least two electrode pads, and to partially expose the thermal pad and the at least two electrode pads through a first surface of the package mold, and exposing the thermal pad and the at least two electrode pads through a surface coplanar with a second surface opposite to the first surface; mounting at least one LED on the thermal pad exposed through the first cavity; wire-bonding the at least one LED to the at least two electrode pads so the at least one LED and the at least two electrode pads are electrically connected to each other; and filling an inside of the first cavity with a molding material.

The filling using the molding material may include covering the thermal pad, the at least two electrode pads, the at least one LED, and the wire, which are exposed through the first cavity.

The forming of the package mold may include further forming a second cavity having a step from the first cavity and being disposed at an upper part of the first cavity.

The method may further include forming a lens unit protruding upward from the first surface by filling an inside of the second cavity with a transparent resin.

The at least one LED may include two electrodes horizontally arranged on an upper surface thereof, and the wire-bonding may include connecting the two electrodes respectively to the at least two electrode pads. The thermal pad may be electrically unpolarized.

The forming of the package mold may include forming the first cavity to include a first recess exposing a region mounting the at least one LED on the thermal pad and a second recess connected with lateral sides of the first recess to partially expose the at least two electrode pads.

The forming of the lead frame may include forming a penetration portion on the at least two electrode pads by penetrating a region to be electrically connected with the wire.

The method may further include pre-cutting a part of the lead frame protruding out of the package mold, after the forming of the package mold.

The method may further include cutting a remaining part of the lead frame protruding out of the package mold, after the filling using the molding material.

Additional aspects, features, and/or advantages of example embodiments will be set forth in part in the description which follows and, in part, will be apparent from the description, or may be learned by practice of the disclosure.

### BRIEF DESCRIPTION OF THE DRAWINGS

These and/or other aspects and advantages will become apparent and more readily appreciated from the following description of the example embodiments, taken in conjunction with the accompanying drawings of which:
FIG. 1 illustrates a light emitting diode (LED) package according to example embodiments;
FIG. 2 illustrates the LED package of FIG. 1, cut along a line I-I';
FIG. 3 illustrates a lower surface of the LED package of FIGS. 1 and 2;
FIGS. 4 through 6 illustrate LED packages according to various types of example embodiments;
FIGS. 7A though 7G illustrate diagrams for describing a method of fabricating an LED package according to example embodiments;
FIGS. 8A though 8C illustrate diagrams for describing a method of fabricating an LED package according to other example embodiments;
FIGS. 9 and 10 each illustrate a connection state of a circuit of an LED package according to example embodiments.

### DETAILED DESCRIPTION

Reference will now be made in detail to exemplary embodiments of the present invention, examples of which are illustrated in the accompanying drawings. In the description of the present invention, if detailed descriptions of related disclosed art or configuration are determined to unnecessarily make the subject matter of the present invention obscure, they will be omitted. Terms to be used below are defined based on their functions in the present invention and may vary according to users, user's intentions, or practices. Therefore, the definitions of the terms should be determined based on the entire specification.

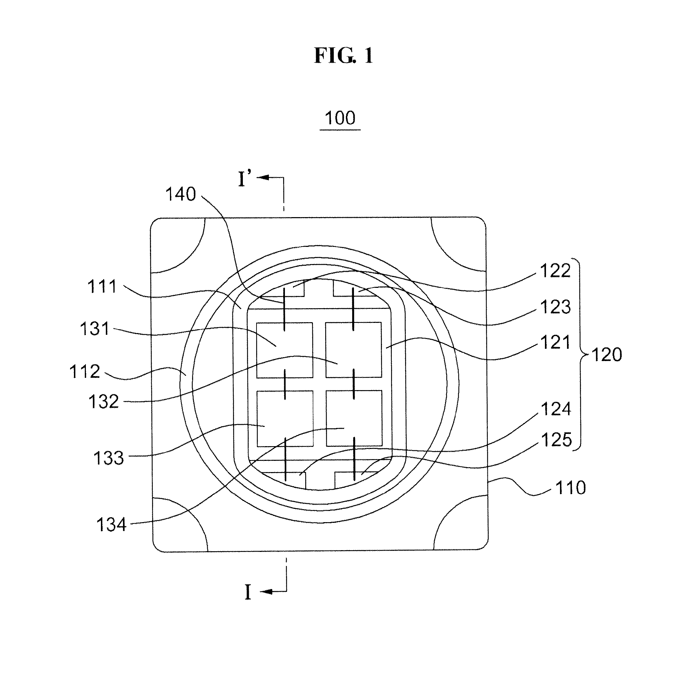

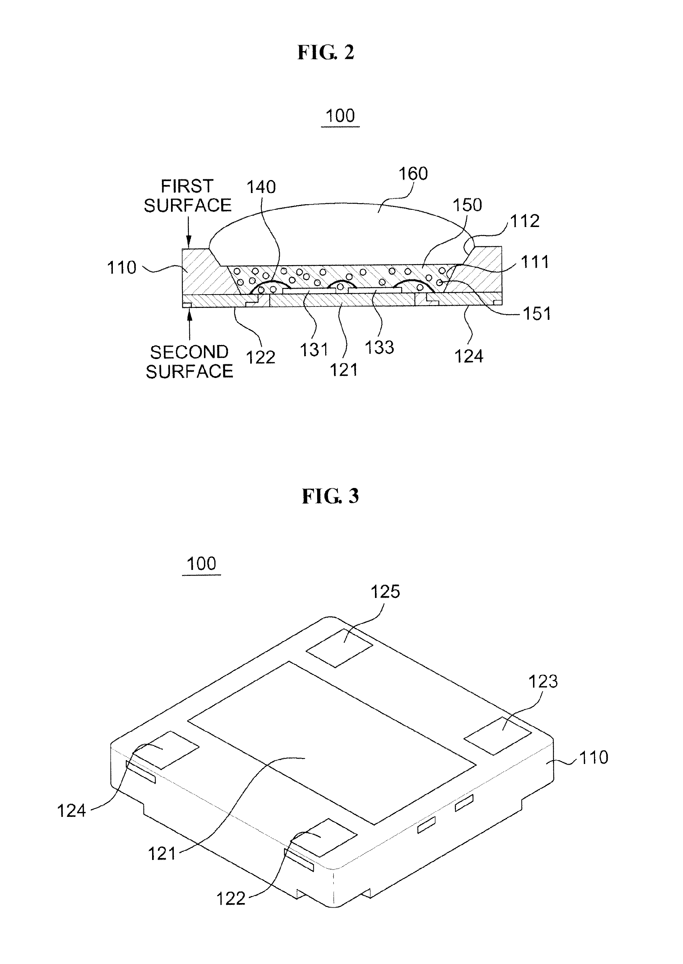

FIG. 1 illustrates a light emitting diode (LED) package 100 according to example embodiments. FIG. 2 illustrates the LED package of FIG. 1, cut along a line I-I'.

Referring to FIG. 1, the LED package 100 includes a package mold 110, a lead frame 120, and a plurality of LEDs, for example, a first LED 131, a second LED 132, a third LED 133, and a fourth LED 134, and a wire 140. Although not shown in FIG. 1, the LED package may further include a molding unit 150 and a lens unit 160 as shown in FIG. 2.

The package mold 110 may include a first surface, for example an upper surface, and a second surface opposite to the first surface, for example a lower surface. A first surface may include a first cavity 111 that supplies a region for mounting the first LED 131 to the fourth LED 134. In this case, the first cavity 111 may have an oval shape.

The package mold 110 may further include a second cavity 112 having a step from the first cavity 111 and being disposed at an upper portion of the first cavity 111.

The first cavity 111 and the second cavity 112 each have an inclined inner wall. Therefore, lights emitted from the first LED 131 to the fourth LED 134 are reflected by the inner walls and extracted to the outside.

The lead frame 120 is inserted in the package mold 110 and includes a thermal pad 121 and a first electrode pad 122, a second electrode pad 123, a third electrode pad 124, and a fourth electrode pad 125.

The thermal pad 121 is separated physically and electrically from the first electrode pad 122 to the fourth electrode pad 125. One surface of the lead frame 120, that is, one surface of the thermal pad 121 and one surface of each of the first electrode pad 122 to the fourth electrode pad 125 are exposed through the first cavity 111 of the package mold 110.

According to example embodiments, only a part of the thermal pad 121, the part for mounting the first LED 131 to the fourth LED 134, may be exposed through the first cavity 111. Also, only a part of the first electrode pad 122 to the fourth electrode pad 125, the part for connection with the wire 140, may be exposed through the first cavity 111.

The other surface of the thermal pad 121 and the other surfaces of the first electrode pad 122 to the fourth electrode pad 125 may be exposed through a surface coplanar with the second surface of the package mold 110.

That is, the first electrode pad 122 to the fourth electrode pad 125 constituting the lead frame 120 may be inserted in the package mold 110 and may be partially exposed to the outside without protruding or extending to the outside of the package mold 110.

In a case where the LED package 100 is mounted on a second circuit board, for example a printed circuit board (PCB), the first electrode pad 122 to the fourth electrode pad 125 exposed through the second surface of the package mold 110 may be connected with wiring patterns arranged on the second circuit board.

According to the above structure of the first electrode pad 122 to the fourth electrode pad 125, the LED package 110 may be surface-mounted on the second circuit board.

The first LED 131 to the fourth LED 134 may be mounted at predetermined intervals from one another on the thermal pad 121. The thermal pad 121 may be made of the same metal as the first electrode pad 122 to the fourth electrode pad 125. In addition, the thermal pad 121 may radiate heat generated from the first LED 131 to the fourth LED 134 to the outside, and may supply the region for mounting of the first LED 131 to the fourth LED 134.

Each of the first LED 131 to the fourth LED 134 may have a horizontal structure where two electrodes are horizontally arranged on an upper surface. Also, the first LED 131 to the fourth LED 134 may be a direct current (DC) LED or an alternating current (AC) LED.

Any one of the electrodes arranged on the upper surface of each of the first LED 131 to the fourth LED 134, for example, an electrode disposed near an outer region of the thermal pad 121, may be electrically connected with an electrode pad nearest to the thermal pad 121 through the wire 140.

For example, as shown in FIGS. 1 and 2, any one of the electrodes arranged on the upper surface of the first LED 131 may be electrically connected with the first electrode pad 122 which is disposed nearby, through the wire 140.

Also, the other electrode arranged on the upper surface of each of the first LED 131 to the fourth LED 134 may be connected with the electrode of the LED disposed nearby.

For example, the other electrode arranged on the upper surface of the first LED 131, which is separated from the first electrode pad 122, may be connected with the electrode of the third LED 133 disposed nearby. Such interconnection may be applied to the second LED 132 and the fourth LED 134 in the same manner.

According to the above electrically connection structure, the thermal pad 121 may only mount the first LED 131 to the fourth LED 134 without being electrically connected with the first LED 131 to the fourth LED 134. Therefore, the thermal pad 121 is electrically unpolarized.

According to the example embodiments, since the thermal pad 121 is electrically unpolarized, when the LED package 100 is mounted on the second circuit board, the thermal pad 121 may not use a dielectric layer on a lower surface for electrical isolation with the second circuit board.

When the thermal pad 121 is electrically polarized, a dielectric layer is to be formed at a lower portion of the thermal pad 121 when the LED package 100 is mounted to the second circuit board. However, since the dielectric layer is made of a low-conductivity material, the heat radiation efficiency may be reduced.

However, since the thermal pad 121 according to the present embodiment is electrically unpolarized, when the LED package 100 is mounted to the second circuit board, the dielectric layer for isolation between the thermal pad 121 and the second circuit board may be omitted while the heat radiation efficiency is secured.

The molding unit 150 is disposed inside the first cavity 111, thereby covering the thermal pad 121, the first electrode pad 122 to the fourth electrode pad 125, the first LED 131 to the fourth LED 134, and the wire 140, which are exposed through the cavity 111. A loop height of the wire 140 is less than a depth of the first cavity 111 so that the wire 140 is covered only with the molding unit 150.

The molding unit 150 may include a fluorescent substance 151. The fluorescent substance 151 may include at least one of a red fluorescent substance, a green fluorescent substance, a blue fluorescent substance, and yellow fluorescent substance.

The lens unit 160 is disposed in the second cavity 112 and may have a hemispheric shape protruding upward from the surface.

Since the thermal pad 121 and the first electrode pad 122 to the fourth electrode pad 125 are inserted in the package mold 110 of the LED package 100, a plurality of LEDs may be mounted on the thermal pad 110 with high integration. Also, the heat radiation efficiency may increase.

FIG. 3 illustrates a perspective view showing the lower surface of the LED package 100 shown in FIGS. 1 and 2. That is, FIG. 3 shows the second surface of the package mold 110.

Referring to FIG. 3, the thermal pad 121 and the first electrode pad 122 to the fourth electrode pad 125 are exposed through the coplanar surface of the second surface of the package mold 110. The thermal pad 121 exposed through the second surface of the package mold 110 may radiate heat from the first LED 131 to the fourth LED 134 directly to the outside.

In addition, since the first electrode pad 122 to the fourth electrode pad 125 are exposed through the coplanar surface of the second surface, the LED package 100 may be surface-mounted on the second circuit board.

Accordingly, the LED package 100 may be reduced in size by the surface mounting.

When the first electrode pad 122 to the fourth electrode pad 125 protrude or extend through lateral sides of the package mold 110, damage may occur due to a short circuit among the electrode pads.

However, the LED package 100 is configured such that the first electrode pad 122 to the fourth electrode pad 125 are exposed through the coplanar surface of the second surface of the package mold 110 as shown in FIG. 3, without protruding or extending out of the package mold 110. Accordingly, a short circuit among the first electrode pad 122 to the fourth electrode pad 125 may be prevented.

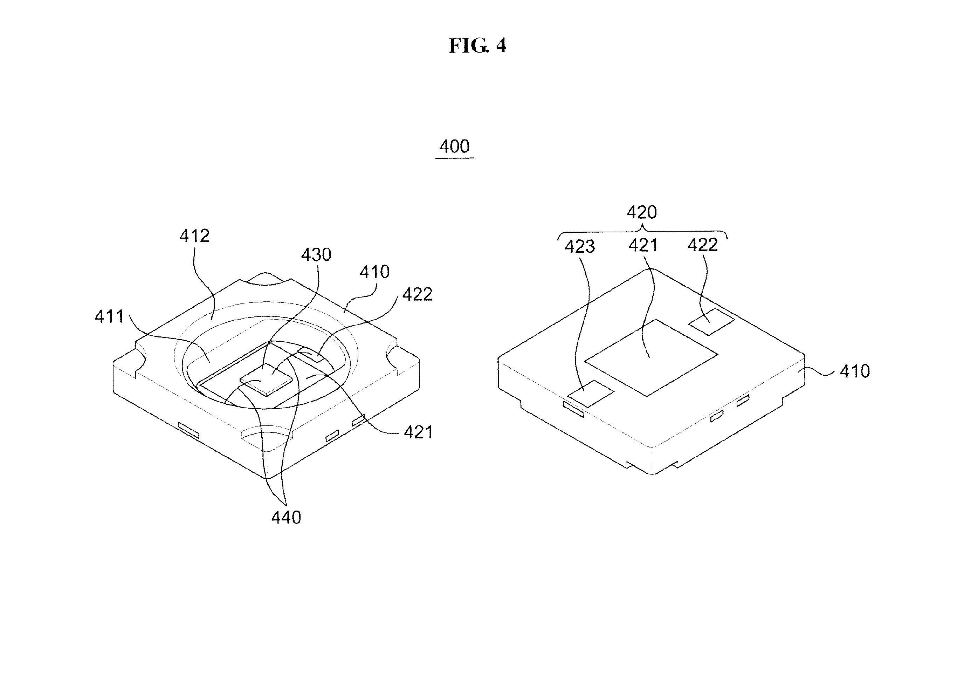

FIGS. 4 through 6 illustrate perspective views of LED packages according to various types of example embodiments.

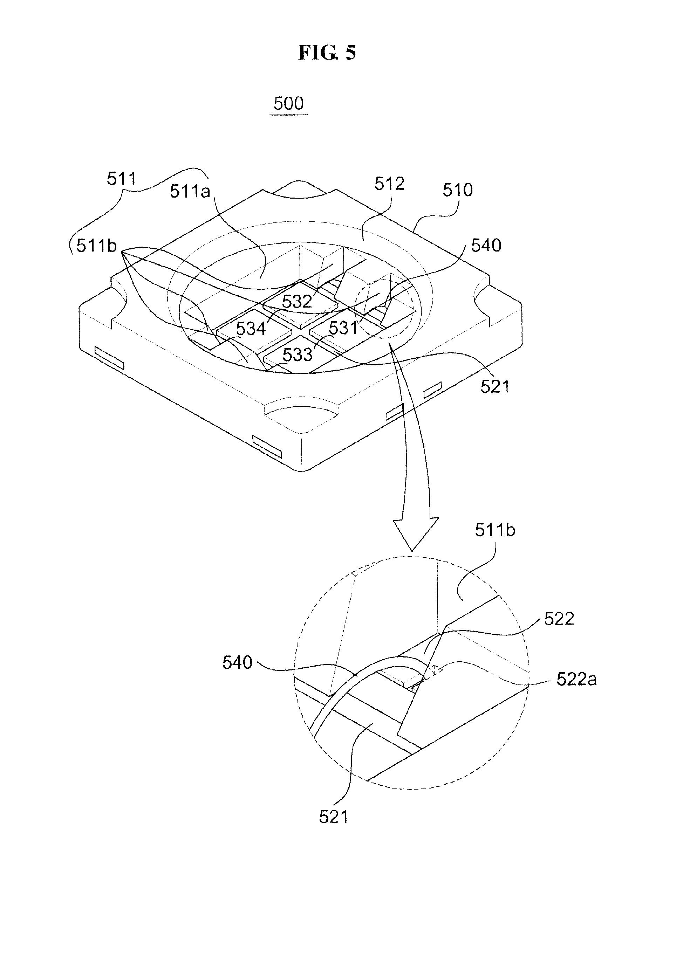

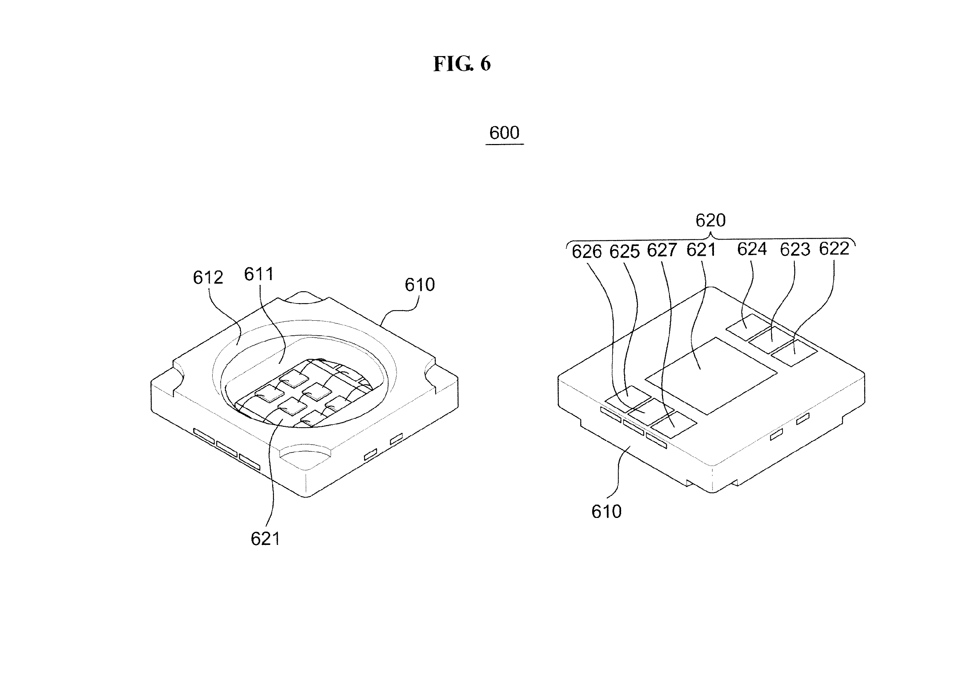

Specifically, FIGS. 4 through 6 show various example embodiments of the LED package according to the number of LEDs mounted in the package mold. FIG. 4 shows an LED package 400 mounting a single LED 430. FIG. 5 shows an LED package 500 mounting four LEDs. FIG. 6 shows an LED package 600 mounting six LEDs.

Referring to FIG. 4, the LED package 400 includes a package mold 410, a lead frame 420, the LED 430, and a wire 440.

The lead frame 420 is inserted in the package mold 410 and includes a thermal pad 421 and first and second electrode pads 422 and 423, the first and second electrode pads 422 and 423 which are separated physically and electrically.

One surface of the thermal pad 421 and one surface of each of the first electrode pad 422 and the second electrode pad 423 are exposed through a first cavity 411 formed on a first surface, that is, an upper surface of the package mold 410. The other surface of the thermal pad 421 and the other surface of each of the first electrode pad 422 and the second electrode pad 423 may be exposed through a coplanar surface of a second surface, that is, a lower surface of the package mold 410.

In addition, the first electrode pad 422 and the second electrode pad 423 are symmetrically disposed on the second surface with respect to the thermal pad 421.

The single LED 430 is mounted on the thermal pad 421 exposed through the first cavity 411. Two electrodes arranged on an upper surface of the LED 430 are electrically connected with a nearest electrode pad among the first electrode pad 422 and the second electrode pad 423 through the wire 430.

FIG. 5 shows the LED package 500 mounting four LEDs. That is, the same number of LEDs is mounted as in the LED package 100 shown in FIG. 1. However, a package mold 510 of the LED package 500 has a different structure from the package mold 110 of FIG. 1.

Referring to FIG. 5, the package mold 510 includes a first cavity 511 and a second cavity 512 disposed on a first surface, that is, an upper surface. A thermal pad 521 and a first electrode pad, a second electrode pad, a third electrode pad, and a fourth electrode pad are partially exposed through the first cavity 511.

The first cavity 511 may have a rectangular structure, different from the oval first cavity 111 of FIG. 1.

More specifically, the first cavity 511 includes a first recess 511 a to expose a region where a first LED 532, a second LED 533, a third LED 534, and a fourth LED 535 are mounted, on the thermal pad 521, and at least one second recess 511b connected to lateral sides of the first recess 511a to partially expose the first electrode pad to the fourth electrode pad.

The first recess 511a and the second recess 511b may have a rectangular shape. The at least one second recess 511b may be disposed on both sides of the first recess 511a and expose parts of the first electrode pad to the fourth electrode pad.

The first LED 532 to the fourth LED 535 mounted on the thermal pad 521 are electrically connected with the first electrode pad to the fourth electrode pad, respectively. More specifically, any one of the two electrodes arranged on the upper surface of each of the first LED 532 to the fourth LED 535 is electrically connected with one of the electrode pads disposed nearby, through a wire 540.

In addition, the other one of the two electrodes arranged on the upper surface of each of the first LED 532 to the fourth LED 535 is electrically connected with one of the electrodes disposed nearby, through the wire 540.

When the first electrode pad to the fourth electrode pad are electrically connected with one of the first LED 532 to the fourth LED 535, respectively, through the wire 540, a loop of the wire 540 may be generated.

When a height of the wire loop increases up to the first cavity 511 and the second cavity 512, the wire 540 may be cut by a thermal shock caused by different properties of the materials disposed in the first cavity 511 and the second cavity 512.

The first electrode pad to the fourth electrode pad may each include a penetration portion to insert the wire 540 in a region where the wire 540 is electrically connected.

Referring to an enlarged view of the first electrode pad 522 in FIG. 5, the first electrode pad 522 is partially exposed through the second recess 511b. The first electrode pad 522 includes a penetration portion 522a in a region for connection with the wire 540. The wire 540 is inserted in and bonded to the penetration portion 522a.

According to the LED package 500 of the present embodiment, since the wire 540 is inserted in the penetration portion 522a, a loop height of the wire 540 does not exceed a depth of the first cavity 511. Therefore, when the cavity 511 is filled with a molding material, the wire 540 is covered with only the molding material and protected from a thermal shock.

The LED package 500 shown in FIG. 5 has a difference from the LED package 100 of FIG. 5 only in the structure of the first cavity 511 disposed on the first surface of the package molding 510. The second surface of the package molding 510 may have the same structure as in the LED package 100.

Referring to FIG. 6, the LED package 600 includes a package mold 610, a lead frame 620, the six LEDs, and a wire.

The lead frame 620 includes a thermal pad 621 mounting the six LEDs, and a first electrode pad 622, a second electrode pad 623, a third electrode pad 624, a fourth electrode pad 625, a fifth electrode pad 626, and a sixth electrode pad 627 connected with the six LEDs, respectively, through the wire.

One surface of the thermal pad 621 and one surface of each of the first electrode pad 622 to the sixth electrode pad 627 are exposed through a first cavity 611 formed on a first surface of the package mold 610. The other surface of the thermal pad 627 and the other surfaces of the first electrode pad 622 to the sixth electrode pad 627 are exposed through a surface coplanar with a second surface of the package mold 610.

As described with FIG. 4 through FIG. 6, the LED package 400, the LED package 500, and the LED package 600 enable high integration of the LEDs by mounting the single LED, four LEDs, and six LEDs at predetermined intervals on the thermal pad 421, the thermal pad 521, and the thermal pad 621, that are respectively electrically unpolarized.

While the thermal pad 421, the thermal pad 521, and the thermal pad 621 respectively including one, four, and six LEDs have been illustrated with the embodiments of FIG. 4 through FIG. 6, the present invention is not limited to the above embodiments and more than six LEDs may be mounted.

In addition, the thermal pad 421, the thermal pad 521, and the thermal pad 621 of the LED package 400, the LED package 500, and the LED package 600 according to the embodiments are exposed through the second surface. Therefore, the heat radiation efficiency is high in comparison with conventional LED packages such as an LED package having a lead frame extruded or extended out of a package mold or a surface-mounted LED package using a ceramic substrate.

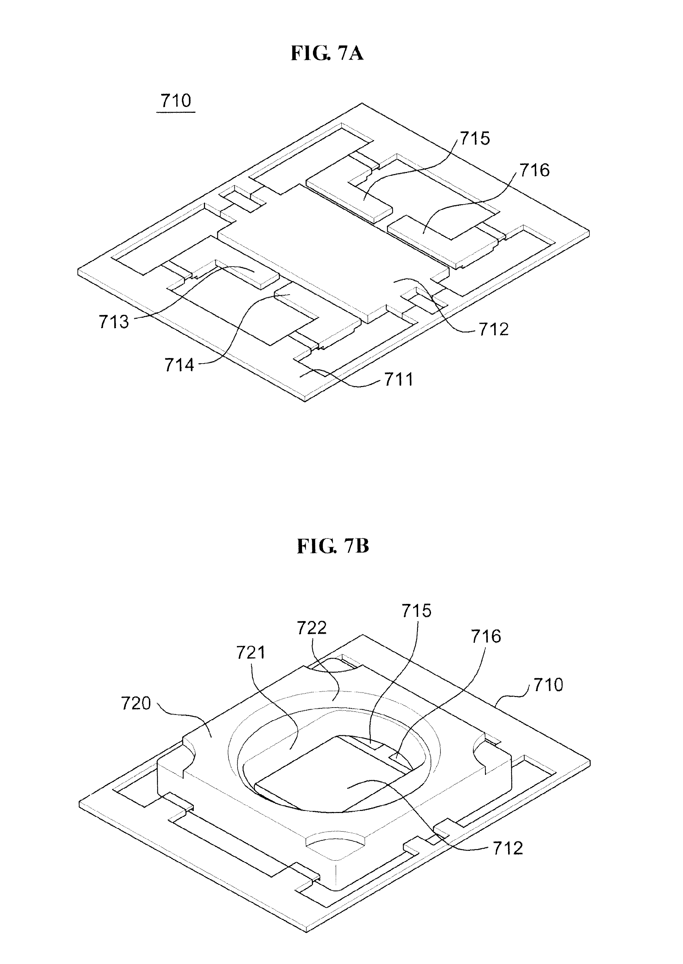

FIGS. 7A though 7G illustrate diagrams for explaining a method of fabricating an LED package according to example embodiments.

Referring to FIG. 7A, the LED package fabricating method includes fabricating of a lead frame 710. The lead frame 710 may be fabricated by etching or punching a single metal substrate or an alloy substrate.

The lead frame 710 may include a lead frame body 711, a thermal pad 712 connected to the lead frame body 711, and a first electrode pad 713, a second electrode pad 714, a third electrode pad 715, and a fourth electrode pad 716.

The thermal pad 712 supplies a region for mounting LEDs. A surface area of the thermal pad 712 may be varied according to the number of LEDs to be mounted. For example, when one LED is to be mounted, the thermal pad 712 may have a surface area covering one LED. When two or more LEDs are to be mounted, the surface area of the thermal pad 712 may increase in proportion to the number of the LEDs.

The first electrode pad 713 to the fourth electrode pad 716 are separated physically and electrically with one another within the lead frame body 711, and are also separated from the thermal pad 712. Also, the first electrode pad 713 and the second electrode pad 714 are symmetrically arranged to the third electrode pad 715 and the fourth electrode pad 716 with respect to the thermal pad 712.

The first electrode pad 713 to the fourth electrode pad 716 of FIG. 7A are provided in consideration of mounting four LEDs on the thermal pad 712. However, the number of the electrode pad may increase or decrease depending on the number of LEDs to be mounted on the thermal pad 712. For example, when a single LED are to be mounted on the thermal pad 712, two electrode pads may be formed each on either side of the thermal pad 712. When six LEDs are to be mounted on the thermal pad 712, three electrode pads may be respectively formed both sides of the thermal pad 712.

During fabrication of the lead frame 710, penetration portions (not shown) may be further provided to the first electrode pad 713 to the fourth electrode pad 716.

That is, the penetration portions may be disposed in regions of the first electrode pad 713 to the fourth electrode pad 716, where the wires are to be connected during a wire-bonding operation that will be performed later.

Referring to FIG. 7B, the LED package fabricating method includes forming of a package mold 720 shaped to receive the lead frame 710, by injection molding.

More specifically, the lead frame 710 is disposed in a mold (not shown) for forming the package mold 720. In this state, a molding material such as an insulating material is injected and cured in the mold and then the mold is removed, thereby forming the package mold 720.

The package mold 720 includes a first surface, that is, an upper surface and a second surface, that is, a lower surface. The first surface includes a first cavity 721 and a second cavity 722. The second cavity 722 has a step from the first cavity 721 and is disposed at an upper portion of the first cavity 721.

The thermal pad 712 and the first electrode 713 to the fourth electrode pad 716 are inserted in the package mold 720. One surface of the thermal pad 712 and one surface of each of the first electrode pad 713 to the fourth electrode pad 716 are partially exposed through the first cavity 721 of the package mold 720.

The other surfaces of the thermal pad 712 and of the first electrode pad 713 to the fourth electrode pad 716 are exposed through a surface coplanar with the second surface of the package mold 720.

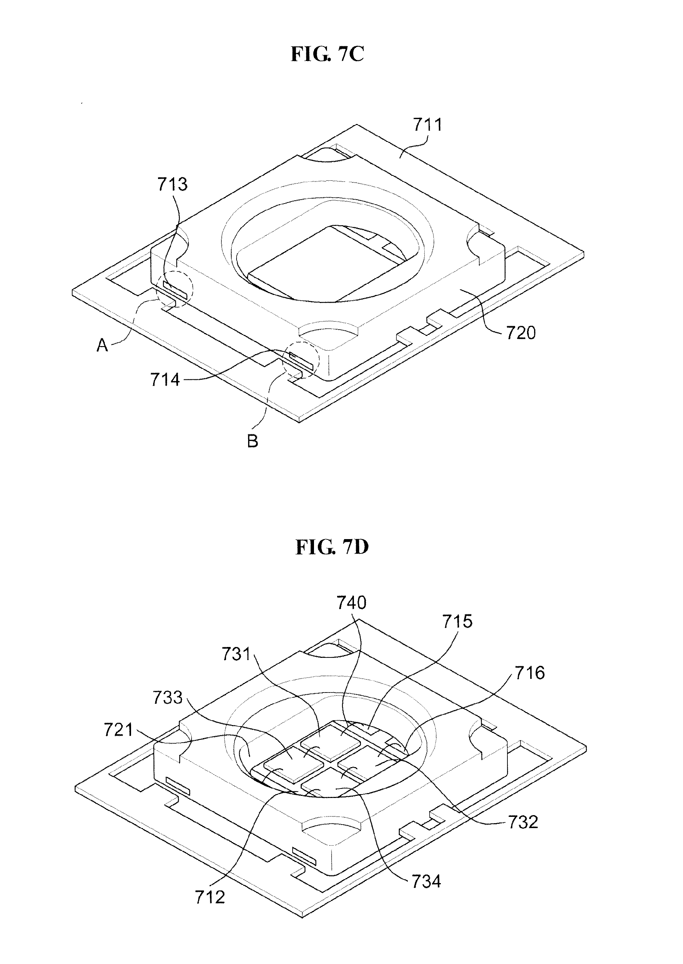

Referring to FIG. 7C, the LED package fabricating method includes pre-cutting of a part of the lead frame 710 protruding to the outside of the package mold 720.

More specifically, connection parts between the lead frame 711 and the first electrode pad 713 to the fourth electrode pad 716 are pre-cut, thereby disconnecting the lead frame 711 and the first electrode pad 713 to the fourth electrode pad 716 from each other.

Accordingly, the first electrode pad 713 and the second electrode pad 714 may be exposed through lateral sides of the package mold 720 as shown in a portion A and a portion B of FIG. 7C.

In addition, although not shown, the third electrode pad 715 and the fourth electrode pad 716 disposed on the opposite side to the first electrode pad 713 and the second electrode pad 714 may also be exposed through lateral sides of the package mold 720 by pre-cutting.

According to the above-described method that pre-cuts a part of the lead frame 710, when the lead frame 711 is cut after the mounting of the LEDs on the package mold 720 and the wire bonding, a shock transmitted to the LEDs and the wire may be reduced. Moreover, damage of the LEDs and the wire may be prevented when the lead frame 711 is completely cut.

Referring to FIG. 7D, the LED package fabricating method includes mounting of a first LED 731, a second LED 732, a third LED 733, and a fourth LED 734 on the thermal pad 712 exposed through the first cavity 721, and wire-bonding the first LED 731, the second LED 732, the third LED 733, and the fourth LED 734 to the first electrode pad 713 to the fourth electrode pad 716, respectively, through a wire 740.

In further detail, the first LED 731 to the fourth LED 734 are fixed on the thermal pad 712 in a 2x2 matrix and at predetermined intervals using a bonding agent that contains metal.

Next, the first LED 731 to the fourth LED 734 are electrically connected with the first electrode pad 713 to the fourth electrode pad 716 by the wire-bonding. Specifically, any one of electrodes arranged on the upper surface of each of the first LED 731 to the fourth LED 734 is bonded through the wire 740 to a nearest electrode pad among the electrode pads. For example, one of the electrodes on the upper surface of the first LED 731 is bonded to the first electrode pad 713 disposed nearby through the wire 740.

The first electrode pad 713 to the fourth electrode pad 716 may each include the penetration portion in the regions to which the wire 740 is bonded. The wire 740 is inserted in and bonded to the penetration portions so that a loop height of the wire 740 maintains a height less than a depth of the first cavity 721.

The other one of the electrodes arranged on the upper surface of each of the first LED 731 to the fourth LED 734 is bonded through the wire 740 to a nearest electrode pad among the electrode pads. For example, the other one of the electrodes on the upper surface of the first LED 731, which is separated from the first electrode pad 713, is bonded to the third LED 733 disposed nearby through the wire 740.

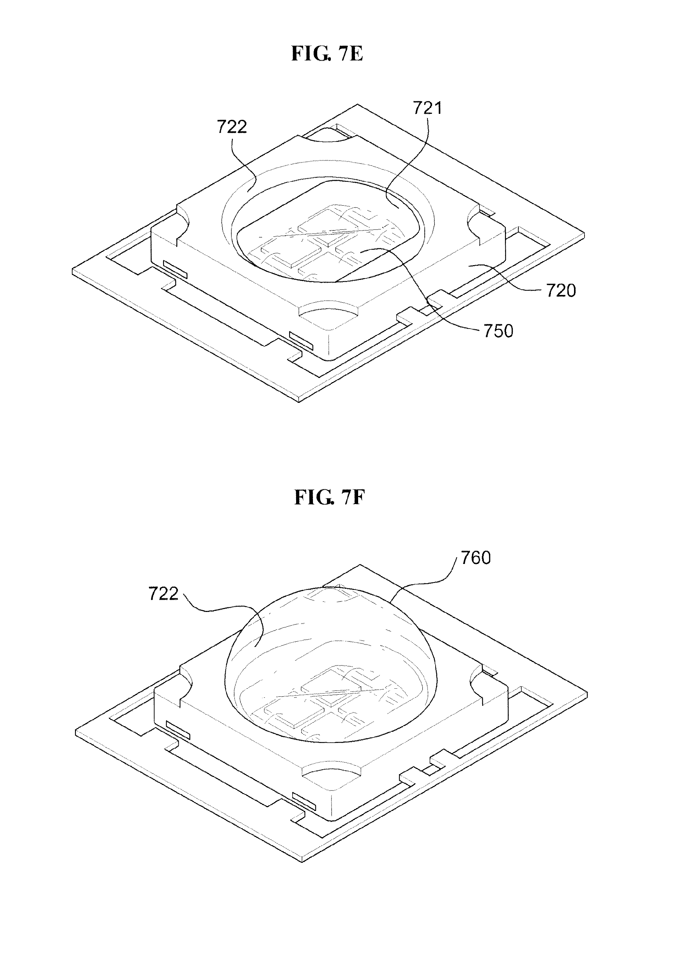

Referring to FIG. 7E, the LED package fabricating method includes filling of an inside of the first cavity 721 formed on the first surface of the package mold 720 with a molding material 750.

The molding material 750 may cover and protect the thermal pad 712, the first electrode pad 713 to the fourth electrode pad 716, the first LED 731 to the fourth LED 734, and the wire 740, which are exposed through the first cavity 721.

The wire 740 may be protected from a thermal shock by being covered only with the molding material 750 within the first cavity 721.

The molding material 750 may be made by mixing epoxy resin or silicon resin with a fluorescent substance or a dispersing agent.

Referring to FIG. 7F, the LED package fabricating method includes forming a lens unit 760 protruded upward from the first surface. The lens unit 760 may be formed by filling an inside of the second cavity 722 disposed on the first surface of the package mold 720 with a transparent resin.

The transparent resin may be epoxy resin or silicon resin.

After the lens unit 760 is formed on the package mold 720 as shown in FIG. 7F, the LED package fabricating method includes cutting of a remaining part of the lead frame 710 protruding out of the package mold 720.

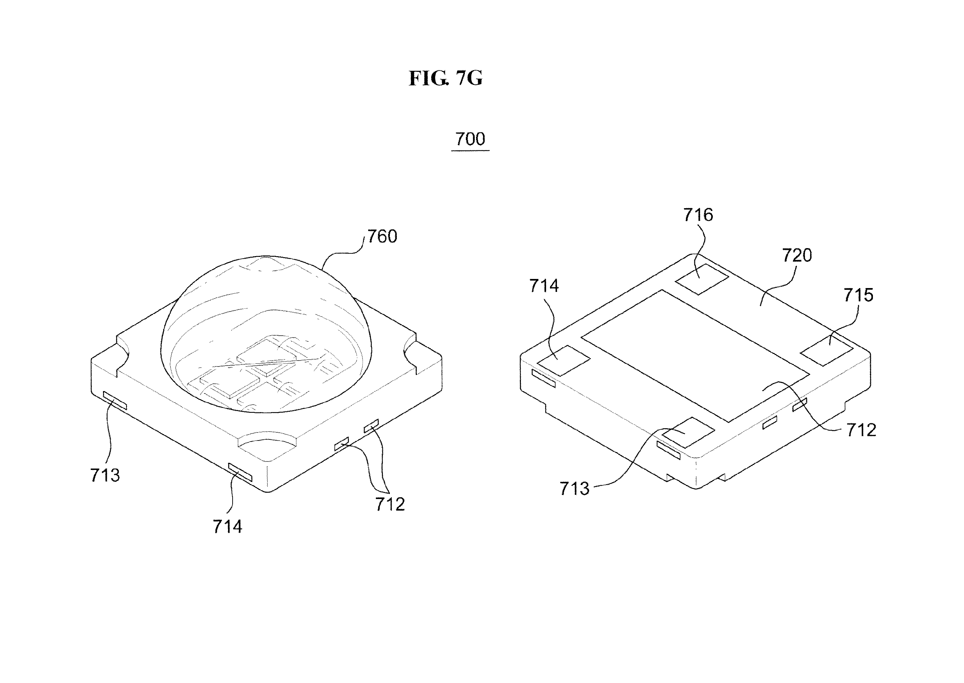

That is, the part of the lead frame 710 connected with the package mold 720 is cut, the part remaining after the pre-cutting of the lead frame 710 as in FIG. 7. The thermal pad 712 may be exposed through the lateral sides of the package mold 720 by the cutting.

In addition, the LED package fabricating method includes separating of the package mold 720 from the lead frame body 711 by cutting, thereby completing the LED package 700.

A lower surface of the LED package 700 is structured such that the thermal pad 712 and the first electrode pad 713 to the fourth electrode pad 716 constituting the lead frame 710 are exposed for surface-mounting to a second circuit board.

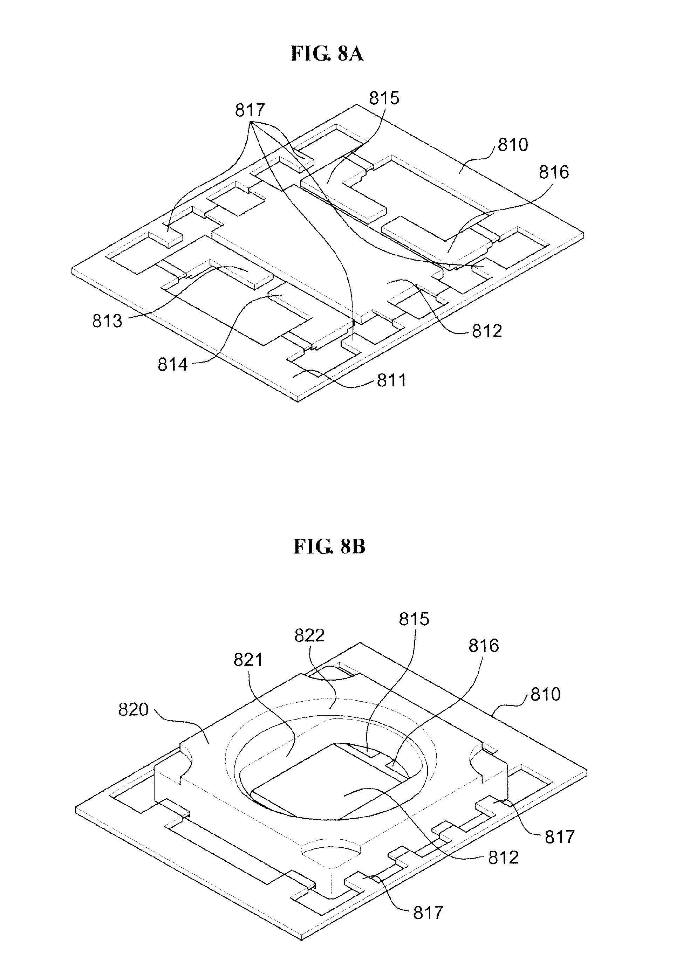

FIGS. 8A though 8C illustrate diagrams for explaining a method of fabricating an LED package according to other example embodiments

Referring to FIG. 8A, the LED package fabricating method includes fabricating of a lead frame 810. The lead frame 810 includes a lead frame body 811, a thermal pad 812 connected with the lead frame body 811, and a first electrode pad 813, a second electrode pad 814, a third electrode pad 815, and a fourth electrode pad 816.

The thermal pad 812 supplies a region for mounting LEDs. The first electrode pad 813 to the fourth electrode pad 816 supply regions for electrically connecting the LEDs with an external circuit.

Different from the lead frame 710 of FIG. 7A, the lead frame 810 may further include a tie bar 817 disposed on both sides of the lead frame body 811. The tie bar 817 interconnects and supports the lead frame body 811 and a package mold 820.

The lead frame 810 of FIG. 8A includes four tie bars 817. However, the number of the tie bar may be properly varied.

Referring to FIG. 8B, the LED package fabricating method includes forming of the package mold 820 shaped to receive the lead frame 810, by injection molding.

More specifically, the lead frame 810 is disposed in a mold (not shown) for forming the package mold 820. In this state, a molding material such as an insulating material is injected and cured in the mold and then the mold is removed, thereby forming the package mold 820.

The package mold 820 includes a first surface, that is, an upper surface and a second surface, that is, a lower surface. The first surface includes a first cavity 821 and a second cavity 822. The second cavity 822 has a step from the first cavity 821 and is disposed at an upper portion of the first cavity 821.

The thermal pad 812 and the first electrode 813 to the fourth electrode pad 816 are inserted in the package mold 820. One surface of the thermal pad 812 and one surface of each of the first electrode pad 813 to the fourth electrode pad 816 are partially exposed through the first cavity 821 of the package mold 820. The other surfaces of the thermal pad 812 and of the first electrode pad 813 to the fourth electrode pad 816 are exposed through a surface coplanar with the second surface of the package mold 820.

The tie bars 817 are partially fixed in the package mold 820 to interconnect and support the lead frame body 811 and the package mold 820.

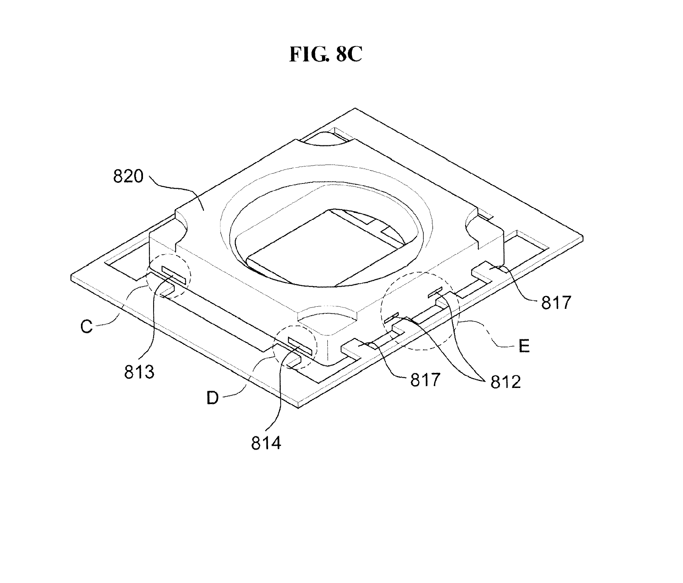

Referring to FIG. 8C, the LED package fabricating method includes pre-cutting a part of the lead frame 810 protruding to the outside of the package mold 820. Here, the protruding part may include a connection part between the lead frame 811 and the thermal pad 812, and connection parts between the lead frame 811 and the first electrode pad 813 to the fourth electrode pad 816.

The pre-cutting cuts connection between the lead frame body 811 and the thermal pad 812 and connection between the lead frame 811 and the first electrode pad 813 to the fourth electrode pad 816.

Therefore, as shown in portions C, D, and E of FIG. 8C, the thermal pad 812, the first electrode pad 813, and the second electrode pad 814 may be exposed through lateral sides of the package mold 820.

In addition, although not shown, the third electrode pad 815 and the fourth electrode pad 816 disposed on the opposite side to the first electrode pad 813 and the second electrode pad 814 may also be exposed through lateral sides of the package mold 820 by pre-cutting.

Since the connection between the lead frame body 811 and the thermal pad 812 and the connection between the lead frame body 811 and the first electrode pad 813 to the fourth electrode pad 816 are cut, the lead frame body 811 and the package mold 820 may be interconnected and supported by the tie bars 817.

As described above, the lead frame body 811 and the package mold 820 are connected only by the tie bars 817. Therefore, when the lead frame body 811 is cut after the mounting of the LEDs on the package mold 820 and wire-bonding are completed, a shock transmitted to the LEDs and the wire may be reduced. As a result, damage of the LEDs and the wire may be prevented.

Next, according to the LED package fabricating method, the LED package may be completed by further performing the procedures as shown in FIG. 7D through FIG. 7G. Specifically, mounting four LEDs on the thermal pad 812, wire-bonding to electrically connect the four LEDs with the first electrode pad 813 to the fourth electrode pad 816, filling the first cavity 821 with the molding material containing a fluorescent substance, forming a lens unit on the second cavity 822, and cutting a remaining part of the lead frame 810 may be further performed.

Especially when cutting the remaining part of the lead frame 810, a connection part between the lead frame 810 and the package mold 820 remaining after pre-cutting the lead frame 810 as in FIG. 8C are cut. In other words, the tie bars 817 are cut, thereby separating the package mold 820 from the lead frame body 811. Since the tie bars 817 are cut, the shock applied to the thermal pad 812 and the electrode pads 813 to 816 may be minimized.

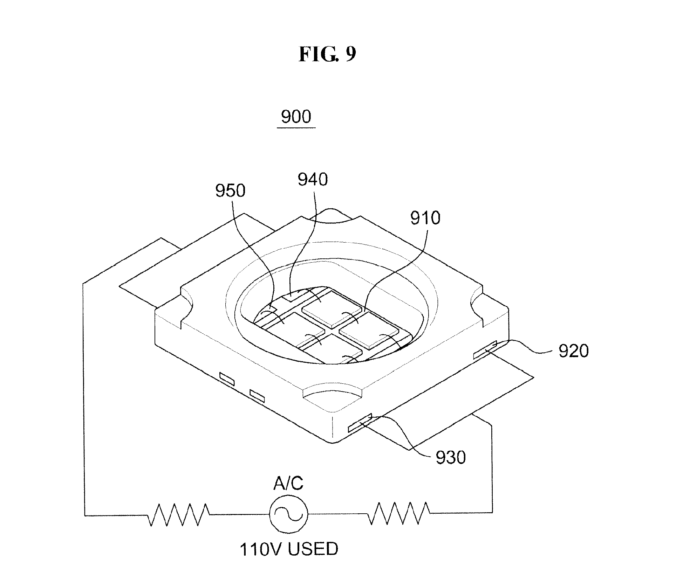

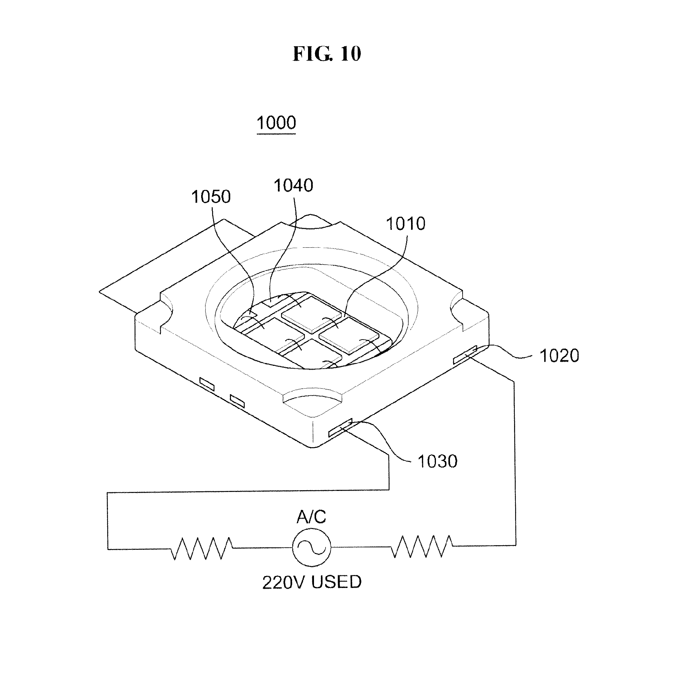

FIGS. 9 and 10 illustrate a connection state of a circuit of an LED package according to example embodiments.

Specifically, FIG. 9 illustrates the connection state of the circuit where an LED package 900 is surface-mounted on a printed circuit board (PCB) having about 110V alternating current (AC). FIG. 10 illustrates the connection state of the circuit where an LED package 1000 is surface-mounted on a PCB having about 220V AC.

The LEDs mounted in the LED packages 900 and 100 shown in FIG. 9 and FIG. 10 may be AC LEDs. Here, the LED packages 900 and 1000 may be identical.

Referring to FIG. 9, the four LEDs of the LED package 900 are mounted on a thermal pad 910 and electrically connected with a first electrode pad 920, a second electrode pad 930, a third electrode pad 940, and a fourth electrode pad 950.

The first electrode pad 920 to the fourth electrode pad 950 are exposed to the outside of the LED package 900, and supply electric power to the four LEDs in connection with a wiring pattern formed on the PCB.

In the PCB of about 110V AC shown in FIG. 9, the first electrode pad 920 and the third electrode pad 940 are parallel-connected with the second electrode pad 930 and the fourth electrode pad 950, respectively.

Referring to FIG. 10, the four LEDs of the LED package 1000 are mounted on a thermal pad 1010 and electrically connected with a first electrode pad 1020, a second electrode pad 1030, a third electrode pad 1040, and a fourth electrode pad 1050.

The first electrode pad 1020 to the fourth electrode pad 1050 are exposed to the outside of the LED package 1000, and supply electric power to the four LEDs in connection with a wiring pattern formed on the PCB.

However, different from in the PCB of about 110V AC of FIG. 9, the first electrode pad 1020 to the fourth electrode pad 1050 are serially connected in the PCB of about 220V AC of FIG. 10.

As shown in FIGS. 9 and 10, the LED package according to the example embodiments may normally operate when surface-mounted to any of the PCB of about 110V AC and the PCB of about 220V AC.

In other words, the LED package is applicable to both the PCB of about 110V AC and the PCB of about 220V AC without having to be separately manufactured for the PCB of about 110V AC and the PCB of about 220V AC.

In addition, the first electrode pad 920 to the fourth electrode pad 950 and the first electrode pad 1020 to the fourth electrode pad 1050 of the LED package 900 and the LED package 1000 are not protruded or extended out of the LED package 900 and the LED package 1000 as in the conventional LED package. Accordingly, a short circuit is not generated among the first electrode pad 920 to the fourth electrode pad 950 and the first electrode pad 1020 to the fourth electrode pad 1050.

Therefore, damage to the LED package by the short circuit are prevented, consequently achieving stable driving of the LED package.

The LED package according to the example embodiments is configured such that at least one LED is mounted on an electrically unpolarized thermal pad. Therefore, high integration of LEDs is possible.

Since heat is radiated through the thermal pad exposed through a lower surface of a package mold, heat radiation efficiency increases.

In addition, a wire may be protected from a thermal shock by a molding material put in a first cavity formed in the package mold.

Also, the LED package according to the example embodiments may be applied to a PCB having all types of voltage without being separately manufactured according to the voltage.

Further, damage caused by a short circuit may be prevented. As a result, the LED package may be stably driven.

Although example embodiments have been shown and described, it would be appreciated by those skilled in the art that changes may be made in these example embodiments without departing from the principles and spirit of the disclosure, the scope of which is defined in the claims and their equivalents.

## Claims

1. A light emitting diode (LED) package comprising:
a lead frame comprising a thermal pad and at least two electrode pads disposed at a distance from the thermal pad;
at least one LED mounted on the thermal pad and electrically connected with the at least two electrode pads through a wire;
a package mold comprising a first cavity to receive the thermal pad and the at least two electrode pads, and to partially expose the thermal pad and the at least two electrode pads through a first surface of the package mold, the first surface on which the at least one LED is mounted, and to expose the thermal pad and the at least two electrode pads through a surface coplanar with a second surface opposite to the first surface; and
a molding unit disposed in the first cavity.

2. The LED package of claim 1, wherein the molding unit covers the thermal pad, the at least two electrode pads, the at least one LED, and the wire, which are exposed through the first cavity.

3. The LED package of claim 1, wherein the package mold further comprises a second cavity having a step from the first cavity and being disposed at an upper portion of the first cavity.

4. The LED package of claim 3, further comprising a lens unit disposed in the second cavity.

5. The LED package of claim 1, wherein
the at least one LED comprises two electrodes horizontally arranged on an upper surface thereof,
the two electrodes are each connected to the at least two electrode pads, and
the thermal pad is electrically unpolarized.

6. The LED package of claim 1, wherein the at least two electrode pads are symmetrically disposed with respect to the thermal pad on the second surface.

7. The LED package of claim 1, wherein the first cavity comprise:
a first recess to expose a region mounting the at least one LED on the thermal pad;
and
a second recess to partially expose the at least two electrode pads, being connected with the first recess.

8. The LED package of claim 1, wherein the at least two electrode pads comprise a penetration portion disposed in a region electrically connected with the wire.

9. A method of fabricating a light emitting diode (LED) package, comprising:
forming a lead frame comprising a thermal pad and at least two electrode pads disposed at a distance from the thermal pad;
forming a package mold by injection molding, the package mold comprising a first cavity to receive in the cavity the thermal pad and the at least two electrode pads, and to partially expose the thermal pad and the at least two electrode pads through a first surface of the package mold, and exposing the thermal pad and the at least two electrode pads through a surface coplanar with a second surface opposite to the first surface;
mounting at least one LED on the thermal pad exposed through the first cavity;
wire-bonding the at least one LED to the at least two electrode pads so the at least one LED and the at least two electrode pads are electrically connected to each other; and
filling an inside of the first cavity with a molding material.

10. The method of claim 9, wherein the filling using the molding material comprises covering the thermal pad, the at least two electrode pads, the at least one LED, and the wire, which are exposed through the first cavity.

11. The method of claim 9, wherein the forming of the package mold comprises further forming a second cavity having a step from the first cavity and being disposed at an upper part of the first cavity.

12. The method of claim 11, further comprising forming a lens unit protruding upward from the first surface by filling an inside of the second cavity with a transparent resin.

13. The method of claim 9, wherein
the at least one LED comprises two electrodes horizontally arranged on an upper surface thereof,
the wire-bonding comprises connecting the two electrodes respectively to the at least two electrode pads, and
the thermal pad is electrically unpolarized.

14. The method of claim 9, wherein the forming of the package mold comprises forming the first cavity to comprise a first recess exposing a region mounting the at least one LED on the thermal pad and a second recess connected with lateral sides of the first recess to partially expose the at least two electrode pads.

15. The method of claim 9, wherein the forming of the lead frame comprises forming a penetration portion on the at least two electrode pads by penetrating a region to be electrically connected with the wire.

16. The method of claim 9, further comprising pre-cutting a part of the lead frame protruding out of the package mold, after the forming of the package mold.

17. The method of claim 16, further comprising cutting a remaining part of the lead frame protruding out of the package mold, after the filling using the molding material.
